Europäisches Patentamt

(19) European Patent Office

Office européen des brevets

(11) Publication number : 0 448 406 A2

(12) **EUROPEAN PATENT APPLICATION**

(21) Application number : 91302514.4

(22) Date of filing : 22.03.91

(51) Int. Cl.⁵ : $H01S\ 3/19$, $H01S\ 3/025$

(30) Priority : 23.03.90 JP 74722/90

(43) Date of publication of application :
25.09.91 Bulletin 91/39

(84) Designated Contracting States :
DE FR GB IT NL

(71) Applicant : THE FURUKAWA ELECTRIC CO.,
LTD.
6-1, Marunouchi 2-chome Chiyoda-ku
Tokyo 100 (JP)

(72) Inventor : Irikawa, Michinori
2-6-3-202, Namiki
Kanazawa-ku, Yokohama-shi (JP)
Inventor : Matsumoto, Narihito
34-2-4-11, Miyagaya
Nishi-ku, Yokohama-shi (JP)
Inventor : Kasukawa, Akihiko
464 Crawford Street
Shrewsbury Township Eatontown, NJ 07724
(US)
Inventor : Okamoto, Hiroshi
1-20-1, Numabukuro
Nakano-ku, Tokyo (JP)

(74) Representative : Gibson, Stewart Harry et al
URQUHART-DYKES & LORD Business
Technology Centre Senghennydd Road
Cardiff CF2 4AY South Wales (GB)

(54) Semiconductor laser diode.

(57) In a semiconductor laser diode having a single- or multi-quantum well structure active layer, and a GRIN-SCH structure light confinement layer, a pair of cleaved facets for forming a resonator are covered with insulator films so as to make one facet low reflectivity and the other high reflectivity. Thus, a high output power in single axial mode can be produced from the low-reflectivity facet of the semiconductor laser diode.

**FIG. 1**
(A)

EP 0 448 406 A2

# SEMICONDUCTOR LASER DIODE

## BACKGROUND OF THE INVENTION

### Field of the Invention

This invention relates to a semiconductor laser diode which can oscillate in a single mode as an optical transmission light source used typically communication. Description of the Prior Art

There have been known as semiconductor laser diodes which oscillate in a single axial mode a distributed feedback laser (DFB) shown in Fig. 3, a distributed Bragg reflection laser (DBR) shown in Fig. 4, and an external cavity laser shown in Fig. 5.

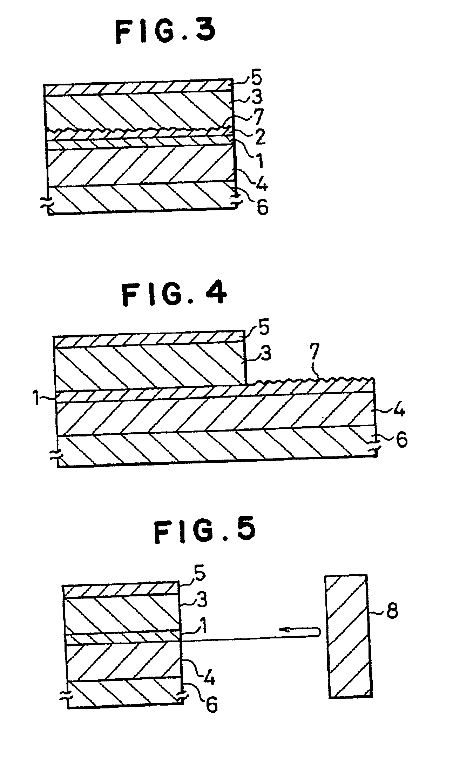

In the DFB type semiconductor laser diode shown in Fig. 3, a lower clad layer 4, an active layer 1, an optical guide layer 2 having a diffraction grating 7, an upper clad layer 3 and a cap layer 5 are sequentially formed on a substrate 6.

In the DFB laser diode shown in Fig. 4, a lower clad layer 4, an active layer 1 having a diffraction grating 7, an upper clad layer 3 and a cap layer 5 are sequentially formed on a substrate 6.

In the external cavity laser diode shown in Fig. 5, a lower clad layer 4, an active layer 1, an upper clad layer 3 and a cap layer 5 are sequentially grown on a substrate 6, and an external mirror 8 is provided outside the grown layer structure.

In addition, a semiconductor laser diode which has active layer of multiquantum well structure (MQW) and a light confinement layer of a GRIN-SCH structure (Graded Index Separate Confinement Heterostructure) to form a resonator through a pair of cleaved surfaces has been disclosed in the following reference 1.

Reference 1: J.J.A.P., A. Kasukawa et al., vol. 128, pp. 661-663 (1989)

The semiconductor laser diode described in the reference 1 is devised as a result of development of a modern MOCVD technique. It is reported that this semiconductor laser diode can oscillate in a single axial mode in a long-wavelength region of $\lambda$ = 1.3 - 1.5 µm.

Heretofore, the single mode semiconductor laser diodes have been used as light sources for a high-speed and long distance digital communication where transmission frequency band is limited due to a spectral dispersion. However, since the intensity noise characteristic of the diode is excellent by about 10 dB/Hz in comparison with a multimode semiconductor laser diode, the semiconductor laser diode has been recently used as light sources for an analog communication.

Since the DFB and DBR type semiconductor laser diodes described above must be formed with the diffraction gratings 7, the manufacturing process of these diodes are complicated

Particularly, the yield of the DFB type semiconductor laser diodes is low as pointed out in the next reference 2.

Reference 2: The publication of the Electronic Information Communication Association, S. Akiba, vol. 70, pp. 471-474 (May 1987).

As apparently described in the reference 2, the DFB-LD has properties which oscillate in two wavelengths of both sides of Bragg Wavelength $_B$ represented by the following equation (1) for satisfying Bragg reflection conditions except when the phases of the cleaved facets and the diffraction grating are in specific ranges.

$$\lambda_B = 2 \, \eta_e \cdot \lambda \quad (1)$$

where
$\eta_e$ : equivalent retractive index
$\lambda$ : period of diffraction grating

Therefore, the following technical considerations are required.

One of the technical considerations is that the DFB-LD is to make an antireflection coating to the front facet of LD cavity in order to have the DFB-LD oscillate at one side of $\lambda_B$. Another is to make antireflection and high-reflection coatings to front and rear facets, respectively, or to shift the phase of the diffraction grating by a quarter of at the center of the resonator, so as to oscillate just in the $\lambda_B$.

However, in all these cases, the manufacturing steps of the DFB laser diodes are complicated, and the yields of the DFB lasers are decreased.

In the above-mentioned external cavity type semiconductor laser diode, it is difficult to manufacture its external mirror with high reproducibility. Therefore, the reproducibility of oscillation wavelength characteristics cannot be provided.

When the end surface output power of the above-mentioned GRIN-SCH-MQW type semiconductor laser diode is increased, the laser spectrum is transferred from a single mode to a multimode. The relative intensity noise of this semiconductor laser diode is increased by about 10 dB/Hz due to above transition from single to multi-mode. Because of this phenomenon, this LD cannot be applied to analog transmission, where high-power and low-noise characteristics are required.

## SUMMARY OF THE INVENTION

An object of the present invention is to provide a semiconductor laser diode which can eliminate the technical disadvantages of the conventional semiconductor laser diode and which can increase the output power, under which the laser can operate in the single axial mode thereof by improving GRIN-SCH-MQW type, GRIN-SCH-SQW type and the like semiconductor laser diodes.

In order to achieve the above-mentioned and other objects of the present invention, there is provided a semiconductor laser diode having an active layer formed on a substrate of a multi- or single-quantum well structure, a light confinement layer formed of a GRIN-SCH structure having a refractive index decreasing gradually from said active layer to clad layer, and a laser cavity formed of a pair of cleaved facets, one of which is high-reflection coated so as to have higher reflectivity than that of one cleaved facet of said resonator, and the other of which is antireflection coated so as to have lower reflectivity than that of the after cleaved facet of said resonator.

The active layer of the semiconductor laser diode of the invention is formed of a single- or multi-quantum well structure. The active layer is preferably formed of GaInAs or GaInAsP materials.

The semiconductor layers on the substrate of the semiconductor laser diode of the present invention are preferably formed by a vapor-phase epitaxial method such as MOCVD method.

Operation

The semiconductor laser diode according to the present invention has not only the active layer of quantum well structure, the GRIN-SCH confinement layer but also cleaved facets, the front side of which is covered with the high-reflectivity reflection film and the rear side of which is covered with the low-reflectivity reflection film. Therefore, as will be described with respect to the embodiment to be described later, a high-output power can be produced in a single axial mode from a predetermined facet of the semiconductor laser diode.

## BRIEF DESCRIPTION OF THE DRAWINGS

The above and other objects as well as advantageous features of the invention will become apparent from the following detailed description of the preferred embodiments taken in conjunction with the accompanying drawings.

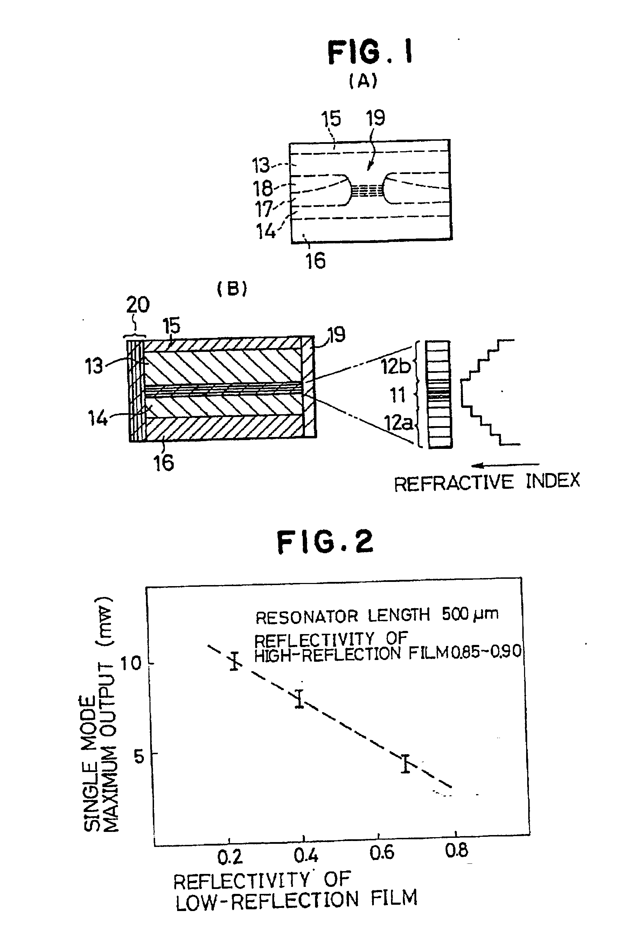

Fig. 1(A) and 1(B) are a front view and a longitudinal sectional side view showing an embodiment of a semiconductor laser diode according to the present invention;

Fig. 2 is a characteristic diagram showing the relationship between the reflectivity of the front facet with antireflection coating and the maximum output power in single axial mode For the semiconductor laser diode of the present invention;

Fig. 3 is a sectional view of a Distributed Feedback (DFB) type semiconductor laser diode according to prior art;

Fig. 4 is a sectional view of a Distributed Bragg Reflector (DBR) type semiconductor laser diode according to prior art;

Fig. 5 is a sectional view of an external composite resonance type semiconductor laser element according to prior art; and

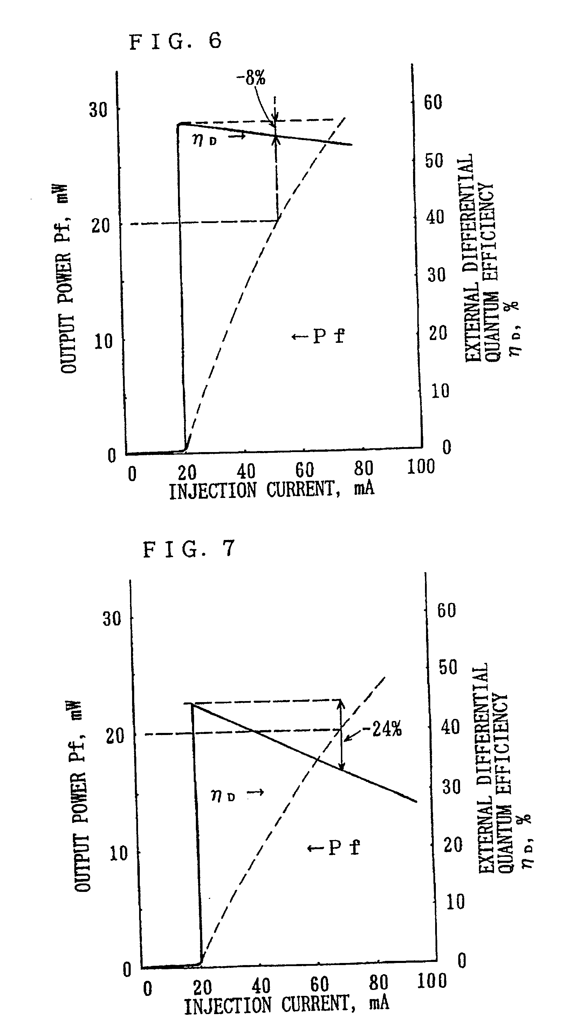

Figs. 6 and 7 show the nonlinearity of the output power vs. Injection current (L-I) characteristics of the semiconductor laser diode according to the present invention and of the prior art, respectively, for GRIN-SCH-MQR.

## DESCRIPTION OF THE PREFERRED EMBODIMENTS

Embodiments of a semironductor laser diode according to the present invention will now be described with reference to Figs. 1(A) and 1(B).

In Figs. 1(A) and 1(B), an n-type InP buffer layer 14, an n-type GRIN-SCH structure light confinement layer 12a, a multiquantum well active layer 11, a p-type GRIN-SCH structure light confinement Layer 12b, a p-type InP clad layer 13, and a p-type GaInAsP cap layer 15 are sequentially grown on an n-type InP substrate 16. A p-type inP current blocking layer 17 and an n-type InP blocking layer 18 are formed at both sides of the active layer 11.

In the semiconductor laser diode of the arrangement described above, one cleaved facet to become an emitting front facet is covered with a low-reflection film 19, and the other cleaved facet to become an opposite rear facet is covered with a multilayer high-reflection film 20.

In the embodiment of the semiconductor laser diode described above, the active layer 11 is formed of a single quantum well structure (SQW) or a multi-quantum well structure (MQW).

When the active layer 11 is formed of the MQW, it is formed of a plurality of well layers and barrier layers alternatively grown.

In the embodiment described above, the GRIN-SCH structure light confinement layers 12a and 12b in which the refractive indexes are decreased gradually from the active layer 11 to clad layers 14 and 15 are so formed that two or more (four in the embodiment) of thin films, of which bandgap wavelengths $\lambda$ are stepwisely increased, are exhibit a quasiparabolic reflective index profile.

These active layer 11 and the light confinement layers 12a and 12b are formed on the n-type InP substrate 16 mainly by means of known or well-known vapor-phase epitaxial method, and the clad layer 14, the cap layer 15 and the current blocking layers 17 and 18 are also formed mainly by means of the vapor-phase epitaxial method.

As one concrete example of the embodiment, an MOCVD method which has excellent controllability of the thickness, composition, etc. of thin films and a mesa etching method are employed, and a semiconductor laser diode as shown in the drawings is manufactured.

The cavity length of a resonator composed of the low-reflection film 19 and the high-reflection film 20 is, for example, 500 μm.

In this case, the low-reflection film 19 is formed of $SiO_x$ or $SiN_x$ having about (1/4) λ of thickness and about 1 to 15 % of reflectivity. The high-reflection film 20 is formed of a multilayer film structure having 80 to 95 % of reflectivity of three pairs of composite films of $SiO_x$ (corresponding to (1/4)λ) and amorphous Si (corresponding to (1/4)λ), and $SiO_x$ (corresponding to (1/4)λ) added thereto.

In the embodiment of the semiconductor laser diode shown in Figs. 1(A) and 1(B), an n-type electrode (not shown) is provided on the rear surface of the lapped substrate 16, and a p-type electrode (not shown) is provided on the upper surface of the cap layer 15.

In the embodiment of the semiconductor laser diode shown in figs. 1(A) and 1(B), when a current is injected between the p-type electrode and the n-type electrode, the active layer region 11 emits a light, the light is reflected and amplified in the active layer region 11 to generate a stimulated emission, and a light is emitted from the active layer region 20 in a predetermined direction.

Fig. 2 shows experimental result for the dependence of the maximum output power under which the laser can operate in signal axial mode on the reflectivity of the front facet for the GRIN-SCH MQW-LDs.

As apparent from Fig. 2, when the reflectivity of the front facet is 10 % or less, the output power of the diode in the single axial mode is increased by 30 to 40 % as compared with the case that the cleaved surface is provided without low reflection film 19.

The above experiment in Fig. 2 was executed in a lot in which the maximum laser power $Pf_{max}$ was relatively low, under which laser can operate in single axial mode.

In other experiment, it was confirmed that, there is a lot in which the laser can operate in single axial mode up to 20 mW, even if both the end surfaces of the semiconductor laser diode remained as cleaved facets.

It is predicted that, if the above-mentioned reflection film is formed on the cleaved surface of such diode, a single mode operation can be achieved by the output up to the vicinity of 30 mW.

The reason why the above-mentioned preferable result is obtained by the semiconductor laser diode of the present invention is considered as below.

In the single mode laser oscillation, when the laser power near the output facet in the laser resonator is Pi, the power density at the center of the resonator is reduced as compared with the Pi, but is regarded as being approximately equal to Pi.

Therefore, the output Pf of the semiconductor laser diode becomes as the following equation (2).

$$Pf = (1 - Rf)Pi \quad (2)$$

where Rf is reflectivity of the emitting front facet.

Here, we assume that the maximum laser power $Pi_{max}$ in the cavity, capable of the single-mode operation is limited to a predetermined value by some mechanism. The maximum output $Pf_{max}$ of the semiconductor laser diode under which laser can operate in a single axial mode when the reflectivity Rf is altered under the above condition becomes as the following equation (3).

$$Pf_{max} = (1 - Rf)Pi_{max} \quad (3)$$

In the equation (3), when the Rf dependency is calculated, wherein the $Pi_{max}$ is constant, the calculated result exhibits a tendency preferably consistent with the experimental result in Fig. 2.

It can be interpreted that in case of the semiconductor laser diode having the active layer 11 of quantum well structure and the light confinement layers of GRIN-SCH structure 12a and 12b, if and when the one cleaved facet of the resonator is covered with the low-reflectivity reflection film 19, while its other facet is covered with the high-reflectivity (80 to 95 %) reflection film, the maximum output power of the single-mode operation is limited by the maximum value of the laser power in the laser cavity.

Therefore, the single-mode output front facet power can be increased in the semiconductor laser diode according to the present invention depending on this.

Next, the improvement of nonlinearity in the output power vs. injection current characteristics of the GRIN-SCH-MQW-LD with (embodiments of the present invention) or without (prior art) the facet coating will be described referring to Figs. 6 and 7, for embodiment of the present invention with facet coating of the reflectivity ratio, 0.85 : 0.1.

In Figs. 6 and 7, the left vertical axis, the right vertical axis, and the horizontal axis stand for the front facet output power, mM, the external differential quantum efficiency n d, %, and the injection current If, mA, respectively. While, the dotted line and the solid line represent the lights output power Pf and its differential value, $\eta_D$, respectively.

The nonlinearity of the LD output characteristics can be defined by the following equation (4).

$$\Delta\eta_D[\eta_D(20 \text{ mW})-\eta_D(\text{max})]/\eta_D(\text{max}) \quad (4)$$

As shown in Fig. 6, $\eta_D$, %, the rate of decrease of the external differential quantum efficiency in 20 mW output is kept as low as about 8 % in the semiconductor laser diode according to the present invention.

On the contrary, as shown in Fig.7, $\eta_D$ dropped by about 24 % that in the prior art.

As described above and illustrated in the drawings, the nonlinearity of of the semiconductor laser diode according to the present invention has been improved remarkably in comparison with that of the prior art.

In the semiconductor laser diode according to, the present invention, the active layer is formed of the quantum well structure, the light confinement layers both sides of the active layer is formed of the GRIN-SCH structure and yet a pair of cleaved facets for forming the resonator are covered with the low-reflectivity reflection film and the high-reflectivity reflection film. Therefore, the semiconductor laser diode of the invention can produce a high output power in the single axial mode. Further, the active layer, the light confinement layer, etc. can be formed by technically skilled thin film growing method, and the low-reflectivity film and the high-reflectivity film may be merely provided on the cleaved surfaces of the element. Consequently, in case of manufacturing the semiconductor laser diode, technical skill is not required, but the yield of the good products of the semiconductor laser diode can be enhanced.

## Claims

1. A semiconductor laser diode having an active layer formed on a substrate of a single- or multi-quantum well structure, a light confinement layer for holding said active layer, formed of a GRIN-SCH structure having a refractive index decreasing gradually from said active layer to clad layer, and a resonator formed of a pair of cleaved facets comprising one cleaved facet with insulator film so as to have higher reflectivity than that of insulator cleaved facet of said resonator, and the other cleaved facet with insulator film so as to have lower reflectivity than that of the other cleaved facet of said resonator.

2. A semiconductor laser diode according to claim 1, wherein said active layer is formed of GaInAs or GaInAsP materials.

3. A semiconductor laser diode according to claim 1, wherein the reflectivity of said facet with high-reflection coating is 80 to 95 %, and the reflectivity of said facet with low-reflection cavity is 15 % or less.

4. A semiconductor laser diode according to any of claims 1 to 3, wherein said semiconductor layers on the substrate are formed by a vapor-phase epitaxial method.

# FIG. 1

## (A)

## (B)

REFRACTIVE INDEX

# FIG. 2

RESONATOR LENGTH 500 μm
REFLECTIVITY OF
HIGH-REFLECTION FILM 0.85~0.90

SINGLE MODE MAXIMUM OUTPUT (mw)

REFLECTIVITY OF
LOW-REFLECTION FILM

# FIG.3

5
3
7
2
1
4
6

# FIG. 4

5
3
7
1
4
6

# FIG.5

5
3
1
8
4
6

F I G. 6

F I G. 7